## Europäisches Patentamt

## European Patent Office

## Office européen des brevets

(11) Veröffentlichungsnummer: **0 294 665**
**A2**

(12) **EUROPÄISCHE PATENTANMELDUNG**

(21) Anmeldenummer: **88108467.7**

(51) Int. Cl.4: **G03F 3/10**

(22) Anmeldetag: **27.05.88**

(30) Priorität: **06.06.87 DE 3719119**

(43) Veröffentlichungstag der Anmeldung:
**14.12.88 Patentblatt 88/50**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Gramm, Ine**
**Bingertstrasse 6**
**D-6200 Wiesbaden(DE)**
Erfinder: **Mohr, Dieter, Dr., Dipl.-Chem.**
**Eaubonner Strasse 8**
**D-6501 Budenheim(DE)**

(54) **Verfahren zur Herstellung eines Mehrfarbenbilds.**

(57) Es wird ein Verfahren zur Herstellung eines Mehrfarbenbilds beschrieben, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein transparentes Bildempfangsmaterial (D) laminiert, die Schicht unter dem zugehörigen Farbauszugsbild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt und das erhaltene Mehrfarbenbild auf einen permanenten Bildträger (H) laminiert, der in Struktur und Aussehen dem Bedruckstoff entspricht, auf den das entsprechende Mehrfarben-Druckbild gedruckt werden soll. Das Verfahren liefert ein Farbprüfbild, das in seinem Aussehen dem Farbandruck näher kommt als ein bisher übliches, nach dem Surprint-Verfahren hergestelltes Prüfbild.

FIG.2b

EP 0 294 665 A2

## Verfahren zur Herstellung eines Mehrfarbenbilds

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster- oder Strichbildes sein und soll den Tonwert der Farben weder erhöht noch herabgesetzt wiedergeben. Die visuelle Farbprüfung soll Fehler in der Vorlage anzeigen, die beste Farbwiedergabe, die beim Drucken in der Druckmaschine von dem Material zu erwarten ist, ermöglichen, die genaue Gradation aller Farbtöne wiedergeben und anzeigen, ob die Grautöne neutral sind, und soll die eventuelle Notwendigkeit zur Abschwächung einer der Farben angeben und/oder Hinweise zur Änderung der Filmvorlage vor der Herstellung der Druckplatten liefern.

Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb andere Farbprüfverfahren entwickelt, die dem Andruck in der Qualität gleichkommen sollen. Zwei Farbprüfverfahren mittels lichtempfindlicher Farbprüffolien sind bekannt, nämlich das Surprint-Verfahren (Übereinanderkopieren) und das Overlay-Verfahren (Übereinanderlegen).

Beim Farbprüfen nach dem Overlay-Verfahren wird auf jeweils einer transparenten Kunststoffolie von jedem Farbauszug für sich ein Teilfarbenbild hergestellt. Zur Herstellung eines Farbprüfsatzes werden dann mehrere solcher mit Teilfarbenbildern versehener transparenter Folien übereinander auf ein weißes Blatt gelegt. Das Overlay-Verfahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von den Drucken unterscheidet, die man mit einem konventionellen Farbandruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturmaßnahmen dienen kann.

Bei der Prüfung nach dem Surprint-Verfahren wird ein Farbprüfbild angefertigt, indem nacheinander Teilfarbenbilder in verschiedenen Farben von verschiedenen Farbauszügen auf einem einzigen Empfangsblatt hergestellt werden. Dazu wird ein undurchsichtiger Träger verwendet, auf den nacheinander lichtempfindliche Schichten in den entsprechenden Farben aufgebracht werden, wie es zum Beispiel in der US-A 3 671 236 beschrieben ist. Das Surprint-Verfahren hat den Vorteil, daß die Farbsättigung nicht durch übereinanderliegende Kunststoffträger beeinflußt wird. Dieses Verfahren kommt dem tatsächlichen Druck näher und vermeidet die dem Overlay-Verfahren eigene Farbverfälschung.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

In der US-A 4 093 464 wird im Beispiel 1 ein Farbprüfverfahren beschrieben, bei dem positiv arbeitende lichtempfindliche Schichten, die in den gewünschten Grundfarben eingefärbt sind und sich jeweils auf einer temporären Trägerfolie befinden, auf dieser Folie belichtet und entwickelt werden. Die erhaltenen Teilfarbenbilder werden auf ein Bildempfangsmaterial, z. B. ein Bedruckpapier, durch Laminieren im Register übertragen. Diese Verfahren haben den Nachteil, daß das Laminieren im Register sehr präzises Arbeiten erfordert und deshalb sehr aufwendig ist. Auch läßt sich das Laminieren von entwickelten Bildern nur mit Schichten durchführen, die noch ausreichend thermoplastisch sind, also in der Regel nur mit positiv arbeitenden Schichten, die zudem noch bestimmte plastifizierende Zusätze enthalten.

In der US-A 4 260 673 wird zur Herstellung eines Mehrfarben-Prüfbilds ein mehrschichtiges Material aus einer gefärbten und einer ungefärbten lichtempfindlichen Positivschicht, einer Haft- und einer Trennschicht und einer temporären Trägerfolie auf ein Bildempfangsmaterial, das ein wasserfest ausgerüstetes weißes Papier ist, laminiert, dort belichtet und zum Teilfarbenbild entwickelt. Die übrigen Teilfarbenbilder werden über dem ersten in gleicher Weise erzeugt. Nach diesem Verfahren lassen sich passergenaue Mehrfarbenbilder leichter erhalten, da nur im Register belichtet zu werden braucht. Das Verfahren hat den Nachteil, daß es für jede Grundfarbe mehrere übereinanderliegende Schichten erfordert und daß die Bildelemente noch jeweils zwei Schichten mit unzersetzter gefärbter Diazoverbindung enthalten.

In der EP-A 182 031 wird ein ähnliches Surprint-Farbprüfverfahren beschrieben, bei dem lichtempfindliche Schichten auf Basis negativ arbeitender Diazoniumverbindungen verwendet werden. Als Bildempfangsmaterial dient eine weiß eingefärbte Polyesterfolie. Die Oberfläche des fertigen Bilds kann mattiert werden, um einen unerwünschten Glanz zu beseitigen.

Vorrangiges Ziel aller dieser Farbprüfverfahren ist es, ein Mehrfarbenbild zu erzeugen, das dem angestrebten Mehrfarbendruck in seinem Aussehen möglichst nahe kommt. Der entscheidende Nachteil der besten bisher gebräuchlichen Surprint-Verfahren ist darin zu sehen, daß das Bildempfangsmaterial oder der permanente Bildträger nicht den in der graphischen Industrie üblichen Bedruckstoffen entspricht. Es werden vielmehr opake Polyesterfolien oder Materialien von ähnlichem Aussehen verwendet, die sich in ihrem Aussehen und ihrer Färbung deutlich von diesen Bedruckstoffen unterscheiden. Der Farbeindruck des Mehrfarbenbilds ist deshalb im Vergleich zu dem gedruckten Bild, das simuliert werden soll, verfälscht. Die Notwendigkeit der Verwendung derartiger Bildempfangsmaterialien ergibt sich aber daraus, daß sie gegen die wiederholte Einwirkung von Entwicklerlösungen, insbesondere von wäßrig-alkalischen Lösungen, beständig sein müssen.

In der älteren Patentanmeldung ......... (USA-Patentanmeldung Ser. No. 38 739 vom 15.4.1987) der Hoechst Celanese Corporation wird dieses Problem dadurch gelöst, daß man das Mehrfarbenbild auf einem Bildempfangsmaterial aufbaut, das damit abtrennbar verbunden ist, auf die andere Seite des Mehrfarbenbilds eine Schutzfolie laminiert, das Bildempfangsmaterial abtrennt und die freigelegte Oberfläche des Mehrfarbenbilds auf ein endgültiges Bildempfangsmaterial laminiert, das dem späteren Bedruckstoff entspricht. Dieses Verfahren liefert insbesondere dann, wenn die Schutzfolie nachträglich entfernt wird, ein Prüfbild, dessen Aussehen dem des entsprechenden Druckbilds weitgehend nahekommt. Es hat den Nachteil, daß man eine ganze Anzahl von beschichteten Folien mit genau differenzierten Haftkraftbereichen benötigt, damit im Laufe des vielstufigen Laminier- und Trennverfahrens die Trennung jeweils zuverlässig an der gewünschten Stelle erfolgt.

Aufgabe der Erfindung war es, ein Farbprüfverfahren vorzuschlagen, bei dem das Mehrfarbenbild nach der Surprint-Technik durch Übertragen der einzelnen lichtempfindlichen Teilfarbenschichten auf ein Empfangsmaterial, Belichten im Register und Entwickeln zum Teilfarbenbild hergestellt wird, bei dem die Betrachtung des Farbprüfbilds auf einem gewünschten Träger, der dem späteren Bedruckstoff entspricht, möglich ist, und bei dem die erforderliche Abtrennung von temporären Schichtträgern mit größerer Sicherheit durchgeführt werden kann.

Erfindungsgemäß wird ein Verfahren zur Herstellung eines Mehrfahrenbilds vorgeschlagen, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein transparentes Bildempfangsmaterial (D) laminiert, die Schicht unter dem zugehörigen Farbauszugsbild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild min destens ein weiteres Teilfarbenbild in einer anderen Grundfarbe im Register zum ersten Teilfarbenbild erzeugt.

Das erfindungsgemäße Verfahren ist dadurch gekennzeichnet, daß man das erhaltene Mehrfarbenbild mit dem Bildempfangsmaterial (D) auf einen Bildträger (H) laminiert, der in Struktur und Aussehen dem Bedruckstoff entspricht, auf den das entsprechende Mehrfarben-Druckbild gedruckt werden soll.

Die beiliegenden Zeichnungen stellen verschiedene Ausführungsformen des erfindungsgemäßen Verfahrens dar.

Fig. 1 zeigt den Aufbau eines lichtempfindlichen Materials, das zur Herstellung des Mehrfarbenbilds eingesetzt wird, und aus einem temporären, abtrennbaren Schichtträger A, einer lichtempfindlichen Schicht B, die in einer der Grundfarben angefärbt ist, und einer Haftschicht C besteht. Die lichtempfindlichen Schichten werden gewöhnlich in den Grundfarben Blaugrün (Cyan), Purpur (Magenta), Gelb und Schwarz eingefärbt, so daß ein Vierfarbenbild erhalten wird.

Fig. 2a zeigt den Aufbau eines Vierfarbenbilds gemäß der Variante I des erfindungsgemäßen Verfahrens. Auf dem transparenten Bildempfangsmaterial D, das mit der untersten Haftschicht $C_1$ untrennbar verbunden ist, wird aus den Haftschichten $C_1$ bis $C_4$ und den aus den lichtempfindlichen Schichten $B_1$ bis $B_4$ erhaltenen, in die Haftschichten eingebetteten Teilfarbenbildern das Vierfarbenbild aufgebaut, dessen oberstes, aus $B_4$ erhaltenes Teilfarbenbild mittels einer mit einer Haftschicht F verbundenen transparenten Deckfolie G geschützt wird.

Fig. 2b zeigt das Farbprüfbild, das aus dem Bild nach Fig. 2a durch Laminieren des mit einer Haftschicht J versehenen Bildträgers H mit D erhalten wird.

Fig. 3a zeigt einen Bildaufbau gemäß Verfahrensvariante II. Der Bildaufbau entspricht dem von Fig. 2a, jedoch mit einem Bildempfangsmaterial D, das mit der untersten Haftschicht $C_1$ über eine zusätzliche Haftschicht E verbunden ist.

Fig. 3b zeigt das fertige Bild, bei dem analog Fig. 2b ein Bildträger H mittels einer Haftschicht J mit dem Bildempfangsmaterial D verbunden ist. Diese Variante unterscheidet sich von der Variante I (Fig. 2a und 2b) allein durch die zusätzliche Haftschicht E.

Fig. 4a zeigt den Bildaufbau gemäß Verfahrensvariante III. Das Bild entspricht dem von Fig. 2a, jedoch ist auf das nicht abtrennbare Bildempfangsmaterial D zusätzlich eine Haftschicht E mit einer abtrennbaren Schutzfolie K aufgebracht.

Fig. 4b zeigt das erste daraus erhaltene Farbprüfbild. Dazu wird die Schutzfolie K abgetrennt und durch den permanenten Bildträger H ersetzt.

Fig. 4c zeigt ein weiteres, aus dem Bild gemäß Fig. 4b erhaltenes Farbprüfbild. Hier ist die Abdeckfolie G abgezogen und an ihre Stelle eine von einer mattierten Schutzfolie L getragene Antiblockierschicht M auf die Schicht F laminiert worden.

Fig. 5a zeigt einen Bildaufbau gemäß Verfahrensvariante IV. Sie unterscheidet sich von der gemäß Fig. 4a durch eine zusätzliche Haftschicht E zwischen erster Haftschicht $C_1$ und untrennbarem Bildempfangsmaterial D.

Fig. 5b zeigt das endgültige Farbprüfbild, das analog Variante III (Fig. 4a und 4b) durch Abtrennen der Schutzfolie K von der Haftschicht $E_2$ und Laminieren des permanenten Bildträgers H mit dieser erhalten wird. Diese Variante führt zu dem gleichen Endprodukt wie Variante II (Fig. 3b), wobei aber die Haftschicht $E_2$ auf das Empfangsmaterial D zusammen mit der Schutzfolie K aufgebracht und nach Abtrennen von K mit dem Bildträger H verbunden wird.

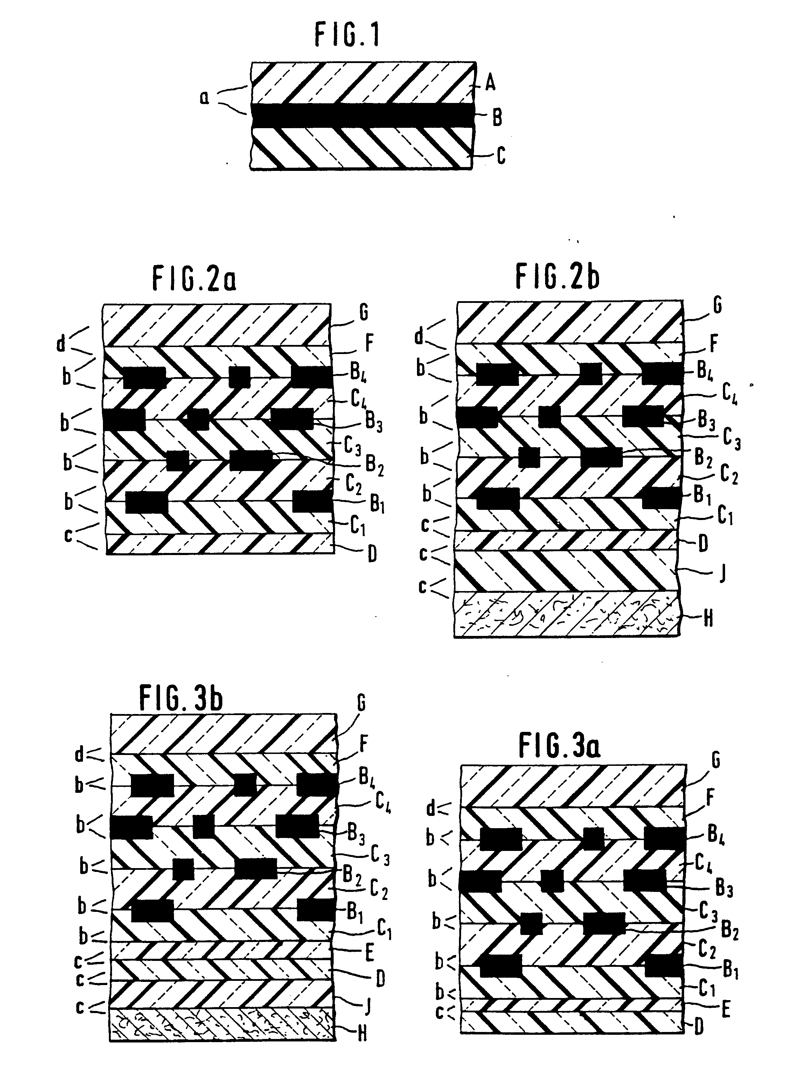

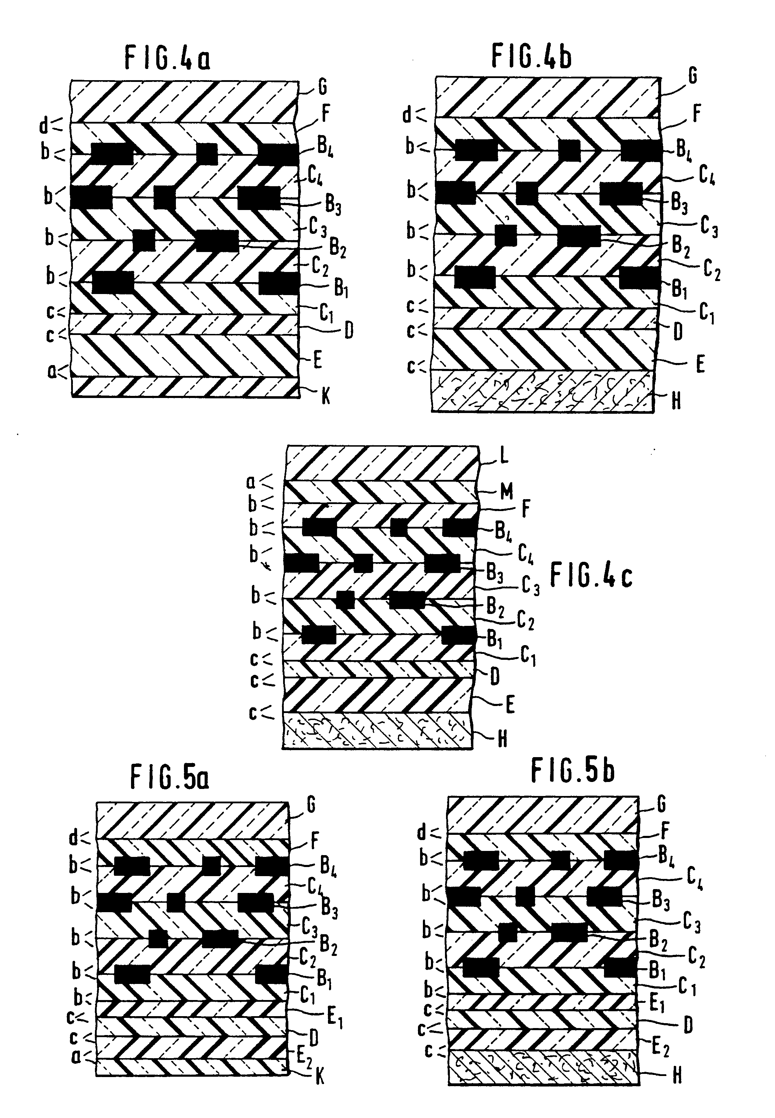

In den Figuren 1 bis 5b bezeichnen die Kleinbuchstaben a bis d die Haftkräfte zwischen den jeweils angegebenen Schichten bzw. Trägern. Mit a wird die Haftkraft zwischen temporärem Träger A und lichtempfindlicher Schicht B (Fig. 1), zwischen der Schutzfolie K und der Haftschicht E bzw. $E_2$ (Fig. 4a, 5a) und zwischen der Schutzfolie L und der Antiblockierschicht M (Fig. 4c) bezeichnet. Mit b wird die Haftkraft zwischen Haft-oder Antiblockierschichten C, E, F, M untereinander bezeichnet, wobei ggf. die Bildelemente von Teilfarbenbildern in die Haftschichten eingebettet sind. Mit c wird die Haftkraft zwischen untrennbarem Bildempfangsmaterial D oder dem permanenten Bildträger H und der jeweiligen Haftschicht bezeichnet. Schließlich gibt d die Haftkraft zwischen der Haftschicht F und der Deckfolie G an.

Wenn das Laminieren in einem handelsüblichen Durchlauf-Laminiergerät bei einer Walzentemperatur von 60 bis 150° C und einer Durchlaufgeschwindigkeit von 0,4 bis 1 m je Minute bei konstant gehaltenem Walzenandruck erfolgt, so sollen sich die Haftkräfte a bis e voneinander unterscheiden und in der folgenden Reihenfolge zunehmen: a - d - c - b.

Vorzugsweise ist die Haftkraft a kleiner als 0,4 N/50 mm, insbesondere kleiner als 0,2 N/50 mm; die Haftkraft d im Bereich von 0,5 bis 3, insbesondere 1 bis 2,5 N/50 mm; die Haftkraft c im Bereich von 3 bis 10, insbesondere 5 bis 8 N/50 mm und die Haftkraft b größer als 10, besonders bevorzugt größer als 15 N/50 mm. Diese Werte werden im Trennversuch, angelehnt an die Vorschrift DIN 53357, Verfahren B, bei einer Streifenbreite von 50 mm und einer Abziehgeschwindigkeit von 400 mm je Minute bestimmt. Bei dem erfindungsgemäßen Verfahren kommt der sorgfältigen Abstimmung der Haftungswerte, insbesondere der Haftkräfte c und d eine entscheidende Bedeutung für die Funktionsfähigkeit des Verfahrens zu. Die Haftkraft a der lichtempfindlichen Schichten B an dem temporären Schichtträger A hat zwar Bedeutung für die Handhabung der ursprünglichen lichtempfindlichen Folien vor der erfindungsgemäßen Weiterverarbeitung; bei dieser Verarbeitung selbst spielt sie jedoch keine Rolle mehr. Für einen möglichst glatten Verfahrensablauf sind jeweils deutliche Unterschiede zwischen den einzelnen Haftkräften besonders vorteilhaft. Es ist jedoch grundsätzlich auch möglich, Verbunde mit zwei abtrennbaren äußeren Folien gleicher Haftkraft an der gewünschten Stelle zu trennen. Das ergibt sich dann, wenn auch der Schichtverbund aus Haftschichten, Teilfarbenbildern und ggf. Antiblockierschicht selbst eine Dicke mindestens in der gleichen Größenordnung wie die jeweilige Deckfolie und eine gegenüber dieser nicht zu vernachlässigende Eigensteifheit hat.

Die Deckfolie G erfüllt verschiedene Funktionen. Sie dient zum einen bei sehr dünnen Bildempfangsmaterialien D zur zusätzlichen mechanischen Stabilisierung des Farbschichtenverbunds. Andererseits beeinflußt sie die Oberflächenstruktur und damit letztlich das Aussehen des resultierenden Farbbilds. Wird eine glänzende oder sogar hochglänzende Bildoberfläche gewünscht, wie es z. B. bei bestimmten Werbegraphiken oder -drucksachen erwünscht ist, verbleibt die glänzende Deckfolie G auf dem Schichtverbund. Wenn man eine matte Bildoberfläche ähnlich einem üblichen Mehrfarbendruckbild erhalten will, wird zweckmäßig die Deckfolie entfernt. Wenn auch dann die Oberfläche der äußeren Haftschicht, durch die Folienoberfläche verursacht, noch zu stark glänzt, kann auf die Oberfläche eine dünne Antiblockierschicht M durch Laminieren mit einer temporären Schutzfolie L mit mattierter Oberfläche und Abziehen der Schutzfolie aufgebracht werden. Diese Ausführungsform ist am Beispiel der Figur 6c dargestellt. Sie ist Gegenstand der älteren europäischen Patentanmeldung 87 104 852.6 der Hoechst Celanese Corporation.

Die Haftkräfte zwischen den verschiedenen Schichten und Folien bzw. Trägermaterialien werden durch die chemische Zusammensetzung der Haftschichten, die Oberflächeneigenschaften der Folien und die Laminierbedingungen beeinflußt. Daraus ergibt sich eine Vielzahl von Möglichkeiten, diese Haftkräfte zu steuern. Um die Herstellung eines Mehrfarbenbilds nach dem erfindungsgemäßen Verfahren zu vereinfachen und verarbeitungsbedingte Fehler weitgehend auszuschließen, werden die verschiedenen Haftkräfte vorzugsweise über die Zusammensetzung der Haftschichten oder durch eine Oberflächenbehandlung der Folien so eingestellt, daß die Herstellung des Schichtverbunds für alle Arbeitsschritte bei der gleichen Temperatur- und Anpreßdruckeinstellung des Laminiergeräts durchgeführt werden kann. Eine geeignete Laminiertemperatur, gemessen als Walzentemperatur am Gerät, liegt üblicherweise im Bereich von 60 bis 140, vorzugsweise von 70 bis 100 und insbesondere von 75 bis 85 ˙ C.

Als Haftschichten (C, E, F, J, M) eignen sich bei dem erfindungsgemäßen Verfahren insbesondere solche, die aus zum Heißsiegeln geeigneten Materialien bestehen.

Hierfür sind im Grunde alle bekannten thermisch erweichbaren Kleber einsetzbar, die bis zu einer Temperatur von mindestens etwa 40 ˙ C griffest und nicht klebrig sind und die bei Temperaturen zwischen 60 und 120 ˙ C erweichen und dabei Haftvermögen entwickeln. Es kommen insbesondere Dispersionen von Vinylacethomo-und -copolymeren, Polymerisate von (Meth)acrylsäurederivaten, z. B. Alkyl(meth)acrylaten, Styrol-Butadien-Latices und andere zur Herstellung von Heißsiegelschichten bekannte Polymerdispersionen sowie deren Abmischungen in Betracht. Beispiele sind Dispersionen von Vinylacetat-Homopolymeren mit Polyvinylalkohol oder Cellulosederivaten, z. B. Celluloseethern, als Schutzkolloiden. Dabei zeigen Dispersionen mit PVA als Schutzkolloid ein schlechteres Siegelverhalten als solche mit Celluloseethern. Weiter sind Dispersionen von Vinylacetat-Maleinsäuredi-n-butylester-, Vinylacetat-Alkylacrylat- und Vinylacetat-Ethylen-Copolymeren geeignet, wobei die letzteren vorzugsweise einen Überschuß an Vinylacateinheiten enthalten sollten. Durch die Art und Menge der Comonomeren können wichtige Eigenschaften, wie Siegeltemperatur, Blockfestigkeit und Haftung eingestellt werden. Nach Möglichkeit sollten die Haftschichten so eingestellt werden, daß sie relativ niedrige Siegeltemperaturen und -drücke sowie kurze Siegelzeiten erfordern. Die Schichten sollten ferner wasserunempfindlich sein und keine Feuchtigkeit aufnehmen.

Wenn die Dispersionen auf Papierblätter, z. B. als permanente Bildträger H, aufgebracht werden sollen, müssen sie eine Mindestteilchengröße haben. So ist für Zeitungsdruckpapier eine Dispersion mit 0,05 - 1 μm Teilchengröße zumeist ungeeignet, da sie in die Poren absinkt und sehr große Mengen zur Beschichtung benötigt werden. Mittel- bis grobdisperse Mischungen mit 0,3 bis 2 oder 0,5 bis 5 μm Teilchengröße sind besser geeignet. Dagegen werden für die Beschichtung von Folien Dispersionen mit kleineren Teilchengrößen, z. B. von 0,05 - 1 μm, bevorzugt.

Als heißsiegelfähige Adhäsive zur Herstellung der Haftschichten für das erfindungsgemäße Verfahren sind im Grunde alle thermisch erweichbaren Kleber einsetzbar, welche bis zu einer Temperatur von ca. 40 ˙ C griffest und nicht klebrig sind, und die bei einer Temperatur zwischen 60 und 120 ˙ C erweichen und dabei Hafteigenschaften entwickeln. Beim erfindungsgemäßen Verfahren bevorzugt sind Haftschichten auf Basis der oben beschriebenen Vinylacetat-Polymeren.

Die Polyvinylacetate werden gewöhnlich in Wasser dispergiert. Sie können auch in einem organischen Lösemittel gelöst und auf die lichtempfindliche Schicht aufgebracht werden. Die Schicht wird dann getrocknet, so daß sich ein Schichtgewicht von etwa 5 bis 30 g/m², bevorzugt von etwa 10 bis 20 g/m² ergibt. In der Schicht können gegebenenfalls UV-Absorber, z. B. Uvinul D-50 (Hersteller GAF), Weichmacher, z. B. Resoflex R-296 (Hersteller Cambridge Industries), sowie Antistatika, z. B. Gafac und Gafstat (Hersteller GAF), und weitere Harze, z. B. Nitrocellulose R 1/2 (Hersteller Hercules), enthalten sein.

Die Schicht soll einen Erweichungspunkt im Bereich von etwa 60 bis 180 ˙ C, vorzugsweise von 60 bis 120 ˙ C, insbesondere von 60 bis 100 ˙ C, haben. In bevorzugter Ausführung ist das Polyvinylacetat in einem Anteil von mehr als 50 Gew.-% in der Haftschicht enthalten. Der Weichmacher kann in einem Anteil von bis zu etwa 30 Gew.-%, der UV-Absorber bis zu etwa 20 Gew.-% und andere Harze bis weniger als 50 Gew.-% in der Schicht anwesend sein.

Eine weitere Möglichkeit, die Haftkraft zwischen Haftschicht und den Zwischenträgerfolien (G, L oder K) zu beeinflussen, liegt in der Modifizierung der Oberflächeneigenschaften dieser Folien. Im Falle der Verfahrensvarianten III und IV wird als Schutzfolie K zweckmäßigerweise eine an der Oberfläche glatte und unbehandelte Polyesterfolie eingesetzt. Zweckmäßigerweise verwendet man dafür Folien im Dickenbereich von 50 bis 180μm. Es sind zwar auch dickere oder dünnere Folien zu diesem Zweck einsetzbar, diese sind jedoch mit gewissen Nachteilen bei der Verarbeitung behaftet. Dünne Folien bereiten aufgrund ihrer Neigung zur Faltenbildung und geringeren Formstabilität Schwierigkeiten beim Laminieren. Dickere Folien erfordern wegen zu geringer Wärmeleitfähigkeit höhere Temperaturen der Laminatorwalzen. Bei Einsatz der Folie als Schutzfolie K sind die optischen Eigenschaften nur von sekundärer Bedeutung, da diese Folien für die endgültige Übertragung auf einen permanenten Bildträger H ohnehin wieder entfernt werden.

Das untrennbare Bildempfangsmaterial D, das im Bildverbund verbleibt, muß optisch völlig klar und die

5

Bindung zu den Haftschichten deutlich stärker sein als bei K. Die Foliendicke kann dabei zwischen 25 und 180μm betragen, wobei dünnere Folien im Bereich von 30 bis 75μm bevorzugt sind.

Sofern mit den angrenzenden Adhäsivschichten eine Haftkraft größer als 3 N/50 mm erzielbar ist, können die obengenannten unbehandelten Folientypen als Bildempfangsmaterial D eingesetzt werden. Wird aufgrund der Zusammensetzung der Adhäsivschicht die geforderte Mindesthaftkraft von 3 N/50 mm nicht erreicht, so können literaturbekannte Methoden zur haftvermittelnden Behandlung der Folienoberfläche eingesetzt und damit die Haftkraft zwischen Folie und Adhäsivschicht in den erforderlichen Bereich angehoben werden. Beispiele derartiger Haftvermittlungsverfahren sind die Behandlung der Folie mit Melamin-Formaldehydharzen, die Behandlung mit Trichloressigsäure, gegebenenfalls in Kombination mit Polyvinylalkohol, die Behandlung mit Polyvinylidenchlorid oder das Eindiffundieren von Acrylsäure in die Polyesteroberfläche. Daneben führen auch physikalische Oberflächenbehandlungen der Folie, z. B. Coronaentladung oder Modifizierung der Oberfläche im Plasma, bevorzugt im $O_2$-, $N_2$- oder $NH_3$-Plasma, zu den gewünschten Steigerungen der Haftkraft.

Als lichtempfindliche Schichten sind positiv oder negativ arbeitende Schichten geeignet, d. h. solche, die durch Belichtung entweder löslich oder gehärtet werden. Sie enthalten außer der lichtempfindlichen Substanz und dem Farbstoff oder Pigment im allgemeinen ein Bindemittel und ggf. weitere Bestandteile, z. B. Weichmacher, Stabilisatoren, Netzmittel, Antistatika und UV-Absorber.

Als negativ arbeitende lichtempfindliche Schichten sind besonders solche auf Basis von Diazoniumsalz-Polykondensationsprodukten oder photopolymerisierbaren Gemischen geeignet. Solche lichtempfindlichen Schichten sind in der EP-A 182 031, 197 396 und 96 326 und der US-A 4 304 836 beschrieben.

Als positiv arbeitende Schichten werden bevorzugt solche auf Basis von Naphthochinondiaziden eingesetzt, wie sie in der EP-A 179 274 beschrieben sind, oder von säurespaltbaren Gemischen, wie sie in den EP-A 42 562 und 22 571 beschrieben sind.

Als permanente Bildträger H können die in der Drucktechnik üblichen Bedruckstoffe, vornehmlich alle gebräuchlichen Papiersorten, die ggf. mit Haftschichten vorbeschichtet sind, eingesetzt werden.

Das Verfahren erlaubt auch das Übertragen eines Mehrfarbenbilds auf eine Vielzahl anderer Materialien, z. B. auf Glas, Metall, Stein oder Holz zu dekorativen oder Werbezwecken.

In den folgenden Beispielen werden bevorzugte Durchführungsformen des erfindungsgemäßen Verfahrens beschrieben. Gewichtsteile (Gt) und Volumteile (Vt) stehen darin im Verhältnis von g zu ccm. Prozentzahlen und Mengenverhältnisse sind in Gewichtseinheiten zu verstehen, wenn nichts anderes angegeben ist.


Beispiel 1

Eine Blaugrün(Cyan)-Farbfolie ·(Fig. 1) wird wie folgt hergestellt: Auf eine 75 μm dicke biaxial verstreckte und thermofixierte Polyethylenterephthalatfolie als temporärer Träger A wird die folgende Beschichtungslösung aufgebracht:
3,33 Gt Maleinsäurepartialester/Styrol-Copolymeres ($M_n$ = 50000; Säurezahl 185 - Scripset 540),
1,17 Gt Maleinsäurepartialester/Styrol-Copolymeres ($M_n$ = 45000; Säurezahl 175 - Scripset 550),
1,33 Gt Polykondensationsprodukt aus 1 mol 3-Methoxy-diphenylamin-4-diazoniumsalz und 1 mol 4,4′-Bis-methoxymethyl-diphenylether,
1,17 Gt Phthalocyaninblau,
0,75 Gt Dimethylphthalat und
0,25 Gt Dibutylphthalat in
41,00 Gt 2-Methoxy-ethanol,
41,00 Gt Butanon und
10,00 Gt Butyrolacton
und getrocknet. Die erhaltene lichtempfindliche Schicht ($B_1$) hat die optische Dichte 1,1 und ein Schichtgewicht von 2 g/m². Auf diese Schicht wird eine Haftschicht $C_1$ von 15 μm Dicke aus 95 % Polyvinylacetat einer Brookfield-Viskosität RVT von 1000-4000 mPa·s, gemessen nach ISO/DIS 2555 bei 20 Umdrehungen/Minute mit der Spindel 3, und 5 % Carboxymethylcellulose aufgebracht. Auf die Haftschicht $C_1$ wird eine 50μm dicke, optisch klare Polyesterfolie, welche beidseitig durch Eindiffundieren von Acrylsäure haftvermittelnd vorbehandelt ist, (Bildempfangsmaterial D), bei 74° C und einer Durchlaufgeschwindigkeit von 65 cm je Minute durch den Walzenspalt eines Laminiergeräts laminiert.

Nach kurzem Abkühlen wird der temporäre Träger A abgezogen und die freigelegte lichtempfindliche Schicht unter einem Blaugrün-Negativ-Farbauszug bildmäßig belichtet. Die belichtete Schicht wird anschließend in einer Entwicklerlösung aus

95,0 % Wasser,
3,0 % Natriumdecylsulfat,
1,5 % Dinatriumphosphat und
0,5 % Natriummetasilikat
entwickelt und getrocknet.

Auf das blaugrüne Teilfarbenbild wird dann eine Purpur(Magenta)-Farbfolie der im folgenden beschriebenen Zusammensetzung laminiert. Auf eine Polyesterfolie A wird eine Beschichtungslösung aus
3,15 Gt Scripset 540,
0,67 Gt hydrolysiertes Scripset 540,
0,70 Gt des für die Blaugrünfolie angegebenen Diazoniumsalz-Kondensationsprodukts,
1,44 Gt Purpurpigment,
0,18 Gt p-Toluolsulfonsäure und
0,88 Gt Dimethylphthalat in
46,48 Gt Butanon und
46,50 Gt 2-Methoxy-ethanol
aufgebracht und zu einer Schichtdicke von 2 g/m² getrocknet. Die Schicht $B_2$ hat die optische Dichte 1,2. Auf diese Schicht wird eine Haftschicht $C_2$ gleicher Zusammensetzung und Dicke wie bei der Blaugrünfolie aufgebracht. Die Verarbeitung zum Teilfarbenbild erfolgt wie oben beschrieben.

In gleicher Weise wird eine Gelb-Farbfolie mit einer lichtempfindlichen Beschichtungslösung folgender Zusammensetzung hergestellt:
2,60 Gt Scripset 540,
2,02 Gt Maleinsäurepartialester/Styrol-Copolymeres ($M_n$ = 1900; SZ 220 - SMA 2625),
1,35 Gt des für die Blaugrünfolie angegebenen Diazoniumsalz-Polykondensationsprodukts,
1,04 Gt gelbes Pigment,
0,25 Gt Dibutylphthalat und
0,75 Gt Dimethylphthalat in
10,00 Gt Butyrolacton,
40,99 Gt Butanon und
41,00 Gt 2-Methoxy-ethanol.

Die Schichtdicke der lichtempfindlichen Farbschicht $B_3$ und die Dicke und Zusammensetzung der darauf aufgebrachten Haftschicht $C_3$ sind die gleichen wie bei den vorstehend beschriebenen Farbfolien. Die optische Dichte ist 0,9. Durch entsprechende Verarbeitung wird das gelbe Teilfarbenbild erhalten.

Schließlich wird in gleicher Weise ein schwarzes Teilfarbenbild erzeugt, wobei zur Beschichtung der Farbfolie die folgende Lösung eingesetzt wird:
3,71 Gt Scripset 540,
2,00 Gt Diazoniumsalz-Polykondensationsprodukt wie bei der Blaugrünfolie,
0,94 Gt schwarzes Pigment,
0,25 Gt Dibutylphthalat,
0,75 Gt Dimethylphthalat und
0,35 Gt p-Toluolsulfonsäure in
10,00 Gt Butyrolacton,
41,00 Gt Butanon und
41,00 Gt 2-Methoxy-ethanol.

Die optische Dichte der Schicht ($B_4$) beträgt 1,5.

Auf das in dieser Weise erhaltene Vierfarbenbild wird eine mit einer Haftschicht F der gleichen Zusammensetzung wie $C_1$ versehene Polyesterdeckfolie G laminiert, die entweder eine matte oder eine glänzende Oberfläche haben kann. Ein derartiges Farbbild auf transparentem Träger kann als solches zur Overhead-Projektion, Schaufensterdekoration usw. Verwendung finden.

Zum Übertragen des derart aufgebauten Schichtverbunds (Fig. 2a) auf einen in der Drucktechnik üblichen Bedruckstoff H, z. B. Papier, wird der Schichtverbund auf ein mit einer Heißsiegelschicht J versehenes Papier H auflaminiert. Je nach Porosität des verwendeten Papiers wird eine Schicht J unterschiedlicher Dicke im Bereich von 10 bis 30 μm eingesetzt, wobei für porösere Papiere dickere Heißsiegelschichten erforderlich sind. Die Schicht besteht aus einem Copolymeren aus 70 % Vinylacetat und 30 % Butylacrylat mit einer Brookfield-Viskosität von 2000-5000 mPa·s.

Ein derart auf Papier erzeugtes Vierfarbenbild wird in der graphischen Industrie als Farbprüfbild (Color Proof) eingesetzt. Es besitzt gegenüber dem in der EP-A 182 031 bzw. der EP-A 179 274 beschriebenen

7

Produkt den Vorteil, daß die Eigenfärbung des Papiers den Farbeindruck des so aufgebauten Vierfarbenbilds mit beeinflußt und somit dem zu simulierenden Vierfarbendruck auf dem gleichen Papier wesentlich näher kommt. Besonders deutlich wird dieser Effekt bei Verwendung von Bedruckstoffen mit starker Eigenfärbung, wie Karton, Zeitungspapieren oder metallisierten Papieren.

## Beispiel 2

Als Bildempfangsmaterial D wird eine beidseitig im $NH_3$-Plasma behandelte, optisch klare Polyesterfolie der Dicke 50 $\mu$m eingesetzt, welche einseitig eine 10 $\mu$m dicke Haftschicht E aus einem Copolymeren von Vinylacetat und Maleinsäure-di-n-butylester einer Brookfield Viskosität (Spindel 5) von 5000-12.000 mPa·s trägt. Entsprechend Beispiel 1 wird auf der Schicht E der Schichtverbund aufgebaut (Fig. 3a) und wie dort - schließlich gemäß Beispiel 2 auf einen mit einer Heißsiegelschicht J versehenen Bedruckstoff H laminiert (Fig. 3b).

Wenn als Deckfolie G eine Folie mit matter Oberfläche und zwischen dieser und der Haftschicht F eine Antiblockierschicht M eingesetzt wird, deren nach Abtrennen der Deckfolie G freigelegte Oberfläche bei Raumtemperatur und geringfügig erhöhten Temperaturen bei Berührung mit anderen Folien nicht blockt, läßt sich der Verbund beim Übertragen auf den Bedruckstoff H schwieriger handhaben, da sich die Deckfolie G relativ leicht ablösen läßt. Diese Ausführungsform mit einer Antiblockierschicht mit mattierter Oberfläche ist zuweilen erwünscht und wird in der älteren europäischen Patentanmeldung 87 104 852.6 beschrieben. Bei ihrer Anwendung hat die Anwendung eines untrennbaren Bildemp fangsmaterials D gemäß der Erfindung den Vorteil, daß der Verbund mechanisch stabiler und leichter zu handhaben ist.

## Beispiel 3

Als Bildempfangsmaterial D wird eine beidseitig im $O_2$-Plasma behandelte, optisch klare Polyesterfolie der Dicke 50 $\mu$m eingesetzt, welche einseitig eine im Beispiel 2 beschriebene Haftschicht E in einer Dicke von 20 $\mu$m trägt, welche ihrerseits mit einer leicht entfernbaren Polyethylenfolie von 25 $\mu$m Dicke als Schutzfolie K für die Verarbeitung überzogen ist.

Im Gegensatz zu Beispiel 2 wird der Schichtverbund auf der freien Seite von D aufgebaut (Fig. 4a).

Zum Übertragen des Vierfarbenbilds wird die Schutzfolie K entfernt und der Schichtverbund über die Haftschicht E auf den Bedruckstoff H laminiert.

## Beispiel 4

Als Bildempfangsmaterial D wird eine 50 $\mu$m dicke beidseitig Corona-behandelte, optisch klare Polyesterfolie eingesetzt, welche auf einer Seite eine Haftschicht $E_1$ der in Beispiel 1 für die Schicht J gegebenen Zusammensetzung und auf der anderen Seite eine Haftschicht $E_2$ der in Beispiel 2 gegebenen Zusammensetzung, welche mit einer Polyethylenfolie geschützt ist, trägt.

Der Schichtverbund wird dann entsprechend Beispiel 1 auf der Haftschicht $E_1$ aufgebaut (Fig. 5a) und entsprechend Beispiel 3 über die Haftschicht $E_2$ auf den Bedruckstoff H übertragen (Fig. 5b).

## Beispiel 5

Zur Bestimmung der Haftkräfte zwischen zwei Haftschichten bzw. zwischen einer Haftschicht und einem Bildempfangsmaterial D oder dem permanenten Bildträger H werden zuerst die jeweiligen Haftschichten in einer Dicke von 15 $\mu$m auf eine rauhe und mit Trichloressigsäure haftvermittelnd behandelte Polyesterfolie aufgebracht. Im Blindversuch wird sichergestellt, daß dieser Verbund eine extrem hohe Adhäsionskraft besitzt.

Ausgehend von derart hergestellten Ausgangstestmaterialien wird unter den in Beispiel 1 angeführten Laminierbedingungen der zu messende Verbund hergestellt.

Zur Messung im Trennversuch werden aus dem Verbund Streifen in einer Breite von 50 mm geschnitten und die zur Trennung erforderliche Kraft bei einer Abzugsgeschwindigkeit von 400 mm/Minute bestimmt. Die Ergebnisse dieser Messungen sind in der nachfolgenden Tabelle zusammengefaßt.

Die in der Tabelle unter "Grenzfläche" aufgeführten Haftschichten bzw. Folien beziehen sich immer auf die Angaben im mitgenannten Beispiel. Als Bedruckstoff H wurde gestrichenes Kunstdruckpapier verwendet.

Tabelle:        Haftkräfte an Grenzflächen

| Grenzfläche | Bei-spiel | Fig. | Zerstö-rungs-freie Trennung | Haftkraft N/50 mm | Zuordnung |
|---|---|---|---|---|---|
| $C_1 - C_2$ | 1 | 2a | nein | $> 20$ | b |
| $C_2 - C_3$ | 1 | 2a | nein | $> 20$ | b |
| $C_3 - C_4$ | 1 | 2a | nein | $> 20$ | b |
| $C_4 - F$ | 1 | 2a | nein | $> 20$ | b |
| $C_1 - D$ | 1 | 2a | bedingt | 6,7 | c |
| $J - D$ | 1 | 2b | bedingt | 5,8 | c |
| $J - H$ | 1 | 2b | nein | 4,9 | c |
| $C_1 - E$ | 2 | 3a | nein | $> 20$ | b |
| $E - D$ | 2 | 3a | nein | 7,3 | c |
| $J - D$ | 2 | 3b | bedingt | 4,5 | c |
| $J - H$ | 2 | 3b | nein | 5,2 | c |
| $C_1 - D$ | 3 | 4a | bedingt | 6,3 | c |
| $E - D$ | 3 | 4a | bedingt | 6,7 | c |
| $E - K$ | 3 | 4a | ja | 0,1 | a |
| $E - H$ | 3 | 4b | nein | 4,7 | c |
| $C_1 - E_1$ | 4 | 5a | nein | $> 20$ | b |
| $E_1 - D$ | 4 | 5a | bedingt | 5,8 | c |
| $E_2 - D$ | 4 | 5a | bedingt | 6,1 | c |
| $E_2 - K$ | 4 | 5a | ja | 0,1 | a |
| $E_2 - H$ | 4 | 5b | nein | 5,4 | c |

**Ansprüche**

1. Verfahren zur Herstellung eines Mehrfarbenbilds, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein transparentes Bildempfangsmaterial (D) laminiert, die Schicht unter dem zugehörigen Farbauszugsbild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt, dadurch gekennzeichnet, daß man das erhaltene Mehrfarbenbild mit dem Bildempfangsmaterial (D) auf einen Bildträger (H) laminiert, der in Struktur und Aussehen dem Bedruckstoff entspricht, auf den das entsprechende Mehrfarben-Druckbild gedruckt werden soll.

2. Verfahren nach Anspruch 1, dadurch gekennzeichnet, daß die Oberfläche des Mehrfarbenbilds nach dem Aufbringen des letzten Teilfarbenbilds durch Aufbringen einer transparenten Deckfolie (G), die eine Haftschicht (F) trägt, auf das oberste Teilfarbenbild geschützt wird.

3. Verfahren nach Anspruch 1, dadurch gekennzeichnet, daß das Mehrfarbenbild mit dem Bildempfangsmaterial (D) unter Verwendung einer zusätzlichen Haftschicht (J) auf den permanenten Bildträger (H) laminiert wird.

4. Verfahren nach Anspruch 1, dadurch gekennzeichnet, daß das Mehrfarbenbild auf dem Bildempfangsmaterial unter Verwendung einer zusätzlichen Haftschicht (E) zwischen der ersten Haftschicht (C) und dem Bildempfangsmaterial (D) aufgebaut wird.

5. Verfahren nach Anspruch 1, dadurch gekennzeichnet, daß das Laminieren in einem Durchlauf-Laminiergerät bei einer Walzentemperatur zwischen 60 und 150° C und einer Durchlaufgeschwindigkeit von 0,4 bis 1 m/Minute durchgeführt wird.

6. Verfahren nach Anspruch 2, dadurch gekennzeichnet, daß man die Haftkräfte zwischen den einander berührenden Schichten, Schichtträgern, Deckfolien und Bildempfangsmaterialien so wählt, daß die Haftkraft (a) zwischen temporärem Schichtträger (A) und lichtempfindlicher Schicht (B) kleiner als 0,4 N/50 mm, die Haftkraft d zwischen der Deckfolie G und der Haftschicht F zwischen 1 und 3 N/50 mm, die Haftkraft (c) zwischen dem permanenten Bildträger (H) und den Haftschichten (J oder E) oder zwischen dem Bildempfangsmaterial D und den Haftschichten (C, E oder J) zwischen 3 und 10 N/50 mm und die Haftkraft (b) zwischen den Haftschichten (C, F, E) untereinander, in die ggf. die Bildelemente der Teilfarbenbilder eingebettet sind, größer als 10 N/50 mm ist.

7. Verfahren nach einem der Ansprüche 1 bis 6, dadurch gekennzeichnet, daß die Haftschichten (C, E, F, J, M) als Hauptbestandteil Vinylacetat- oder Alkylacrylat-Polymere oder Styrol/Butadien-Copolymere enthalten.

8. Verfahren nach einem der Ansprüche 1 bis 7, dadurch gekennzeichnet, daß die Haftschichten 5 bis 50 μm dick sind.

9. Verfahren nach Anspruch 1, dadurch gekennzeichnet, daß die lichtempfindlichen Schichten 0,5 bis 5 μm dick sind.

10. Verfahren nach Anspruch 1, dadurch gekennzeichnet, daß die lichtempfindlichen Schichten negativ arbeiten.

# FIG.1

# FIG.2a

# FIG.2b

# FIG.3b

# FIG.3a

FIG.4a

FIG.4b

FIG.4c

FIG.5a

FIG.5b